# EUROPEAN PATENT APPLICATION

(11) **EP 4 761 555 A1**
(43) Date of publication of application: **17.06.2026**
(21) Application number: 24857801.5
(22) Date of filing: 23.04.2024
(51) Int. Cl.: H10N 97/00

(54) **CHIP AND PREPARATION METHOD THEREFOR, AND ELECTRONIC DEVICE**

(30) Priority: 29.08.2023 CN 202311103485
(71) Applicant: HUAWEI TECHNOLOGIES CO., LTD., Shenzhen 518129 (CN)
(72) Inventor: TAN, Wanliang, Shenzhen, Guangdong 518129 (CN); MA, Wenlong, Shenzhen, Guangdong 518129 (CN); LI, Yuxing, Shenzhen, Guangdong 518129 (CN); HE, Yumin, Shenzhen, Guangdong 518129 (CN); XU, Jeffrey Junhao, Shenzhen, Guangdong 518129 (CN)
(74) Representative: Pfenning, Meinig & Partner mbB
(86) International application number: PCT/CN2024/089338
(87) International publication number: WO 2025/044251

(57) **Abstract**

This application provides a chip and a preparation method therefor, and an electronic device, and relates to the semiconductor field. A large tensile stress may be generated by using a stress application layer, so that a volume change of a ferroelectric layer caused by a phase change is effectively suppressed, a thermal budget is reduced, and damage to the ferroelectric layer caused by a high-temperature annealing process is mitigated. The chip includes a substrate, and a first electrode, a ferroelectric layer, and a second electrode that are sequentially stacked on the substrate. A surface that is of the ferroelectric layer and that faces the second electrode is a first surface, the second electrode covers a part of the first surface, and a part that is of the first surface and that is not covered by the second electrode is a first subsurface. The chip further includes a stress application layer made of a dielectric material, a coefficient of thermal expansion of the stress application layer is less than a coefficient of thermal expansion of the second electrode, and the stress application layer extends from the first subsurface to a side wall of the second electrode.

## Description

This application claims priority to Chinese Patent Application No. 202311103485.2, filed with the China National Intellectual Property Administration on August 29, 2023 and entitled "CHIP AND PREPARATION METHOD THEREFOR, AND ELECTRONIC DEVICE", which is incorporated herein by reference in its entirety.

### TECHNICAL FIELD

This application relates to the semiconductor field, and in particular, to a chip and a preparation method therefor, and an electronic device.

### BACKGROUND

A core part of a ferroelectric memory includes a ferroelectric capacitor. The ferroelectric capacitor includes a first electrode, a ferroelectric layer, and a second electrode that are sequentially stacked. Polarization switching occurs on the ferroelectric layer under electric fields of different directions, causing charging and discharging of the capacitor, thereby achieving a storage state of "0" or "1".

Coefficients of thermal expansion (coefficients of thermal expansion, CTE) of a material of the first electrode and a material of the second electrode have great impact on remnant polarization (remnant polarization, Pr) of the ferroelectric layer. If the coefficients of thermal expansion of the first electrode and the second electrode are excessively large, it is not conducive to formation of a ferroelectric O phase (ferroelectric orthorhombic phase) of the ferroelectric layer. A volume change of the ferroelectric layer caused by a phase change cannot be suppressed due to an insufficient stress. As a result, ferroelectric performance cannot be effectively improved. In this case, a high annealing temperature is required to compensate for the insufficient stress. This is prone to damaging the ferroelectric layer during annealing.

### SUMMARY

To resolve the foregoing technical problems, this application provides a chip and a preparation method therefor, and an electronic device, so that a large tensile stress can be generated by using a stress application layer, to suppress formation of a dielectric M phase and increase a proportion of a ferroelectric O phase, thereby effectively suppressing a volume change of a ferroelectric layer due to a phase change, and a thermal budget can be further reduced, to mitigate damage to the ferroelectric layer caused by a high-temperature annealing process.

According to a first aspect, this application provides a chip. The chip includes a substrate, and a first electrode, a ferroelectric layer, and a second electrode that are sequentially stacked on the substrate. A surface that is of the ferroelectric layer and that faces the second electrode is a first surface, the second electrode covers a part of the first surface, and a part that is of the first surface and that is not covered by the second electrode is a first subsurface. The chip further includes a stress application layer made of a dielectric material, a coefficient of thermal expansion of the stress application layer is less than a coefficient of thermal expansion of the second electrode, and the stress application layer extends from the first subsurface to a side wall of the second electrode.

In this application, a size of the second electrode is reduced, to cover the stress application layer on the first subsurface. The coefficient of thermal expansion of the stress application layer is less than the coefficient of thermal expansion of the second electrode. Therefore, in a high-temperature environment, a deformation of the stress application layer is less than a deformation of the second electrode, and a stronger chemical bond can be formed. For example, when the stress application layer and the second electrode are prepared, an annealing process is performed on the stress application layer and the second electrode separately. The deformation of the stress application layer is less than the deformation of the second electrode. In this way, although the ferroelectric layer is likely to deform in the high-temperature environment, because the stress application layer is in contact with the first subsurface, the stress application layer with a small deformation may be used to provide an in-plane tensile stress for the ferroelectric layer that is likely to deform, so that a lateral deformation of the ferroelectric layer is reduced. Further, the stress application layer further extends to the side wall of the second electrode. In this case, the stress application layer may be further used to provide a longitudinal tensile stress for the ferroelectric layer, so that a longitudinal deformation of the ferroelectric layer is reduced. In other words, the stress application layer with a small coefficient of thermal expansion may generate a large tensile stress in a cooling process. The tensile stress may suppress formation of a dielectric M phase and increase a proportion of a ferroelectric O phase, to effectively suppress a volume change of the ferroelectric layer due to a phase change, thereby effectively improving ferroelectric performance.

Based on this, because the coefficient of thermal expansion of the stress application layer is smaller than that of the second electrode, and an overall tensile stress applied by the stress application layer and the second electrode to the ferroelectric layer are increased, a high annealing temperature is not required to compensate for an insufficient stress. Therefore, in a process of preparing the stress application layer, a temperature required for performing high-temperature annealing on the stress application layer is low, so that a thermal budget can be reduced. In comparison with a related technology, in this application, when a high-temperature annealing process is performed on the stress application layer, less damage is caused to the ferroelectric layer.

In some possible implementations, the stress application layer encircles the second electrode, to provide a larger stress for an entire edge of the ferroelectric layer by using the stress application layer.

In some possible implementations, the first electrode, the ferroelectric layer, and the second electrode are sequentially disposed on the substrate in a second direction. In this case, the first electrode is a bottom electrode, and the second electrode is a top electrode.

In some possible implementations, a surface that is of the ferroelectric layer and that faces the first electrode is a second surface, the first electrode covers a part of the second surface, and a part that is of the second surface and that is not covered by the first electrode is a second subsurface. The coefficient of thermal expansion of the stress application layer is less than a coefficient of thermal expansion of the first electrode, and the stress application layer further extends from the second subsurface to a side wall of the first electrode.

A size of the first electrode is reduced, to cover the stress application layer on the second subsurface. The coefficient of thermal expansion of the stress application layer is less than the coefficient of thermal expansion of the first electrode. Therefore, in the high-temperature environment, the deformation of the stress application layer is less than a deformation of the first electrode, and a stronger chemical bond can be formed. For example, when the stress application layer and the first electrode are prepared, an annealing process is performed on the stress application layer and the first electrode separately. The deformation of the stress application layer is less than the deformation of the first electrode. In this way, although the ferroelectric layer is likely to deform in the high-temperature environment, because the stress application layer is in contact with the second subsurface, the stress application layer with the small deformation may be used to provide an in-plane tensile stress for the ferroelectric layer that is likely to deform, so that the lateral deformation of the ferroelectric layer is reduced. Further, the stress application layer further extends to the side wall of the first electrode. In this case, the stress application layer may be further used to provide a longitudinal tensile stress for the ferroelectric layer, so that the longitudinal deformation of the ferroelectric layer is reduced. In other words, the stress application layer with the small coefficient of thermal expansion may generate a large tensile stress in the cooling process. The tensile stress may suppress formation of the dielectric M phase and increase the proportion of the ferroelectric O phase, to effectively suppress the volume change of the ferroelectric layer due to the phase change, thereby effectively improving the ferroelectric performance.

Based on this, because the coefficient of thermal expansion of the stress application layer is smaller than that of the first electrode, and the overall tensile stress applied by the stress application layer and the second electrode to the ferroelectric layer are increased, the high annealing temperature is not required to compensate for the insufficient stress. Therefore, in the process of preparing the stress application layer, the temperature required for performing high-temperature annealing on the stress application layer is low, so that the thermal budget can be reduced. In comparison with the related technology, in this application, when the high-temperature annealing process is performed on the stress application layer, less damage is caused to the ferroelectric layer.

In some possible implementations, the stress application layer completely covers side walls of the first electrode and the second electrode; and/or the stress application layer completely covers the first subsurface and the second subsurface. The stress application layer completely covers the first subsurface and the second subsurface, to provide the in-plane tensile stress for the ferroelectric layer to a maximum extent, and reduce a lateral deformation of a part that is of the ferroelectric layer and that is in contact with the stress application layer.

In some possible implementations, for conductive materials, tungsten has a small coefficient of thermal expansion and is common. In this case, the coefficient of thermal expansion of the stress application layer is less than the coefficient of thermal expansion of the tungsten, to remove a part of the second electrode (or the first electrode and the second electrode) to form the stress application layer, and provide the ferroelectric layer with a tensile stress that cannot be provided by the second electrode (or the first electrode and the second electrode). For example, a material of the stress application layer includes at least one of silicon dioxide, quartz, graphite, hexagonal boron nitride, silicon nitride, silicon, silicon germanium, and silicon carbide.

According to a second aspect, this application provides a chip. The chip includes a substrate and a three-dimensional ferroelectric capacitor disposed on the substrate. The three-dimensional ferroelectric capacitor includes a first electrode, a ferroelectric layer, a plurality of second electrodes, and a plurality of dielectric layers. In a direction from the substrate to the three-dimensional capacitor, the plurality of second electrodes and the plurality of dielectric layers are alternately disposed, the ferroelectric layer and the first electrode penetrates the plurality of second electrodes and the plurality of dielectric layers, and the ferroelectric layer is disposed between the plurality of second electrodes and the first electrode. The chip further includes a stress application layer made of a dielectric material. A coefficient of thermal expansion of the stress application layer is less than a coefficient of thermal expansion of the dielectric layer, and the stress application layer extends from between the second electrode and the dielectric layer that are adjacent to each other to between the second electrode and the ferroelectric layer.

In this application, the coefficient of thermal expansion of the stress application layer is less than the coefficient of thermal expansion of the dielectric layer. Therefore, in a high-temperature environment, a deformation of the stress application layer is less than a deformation of the dielectric layer, and a stronger chemical bond can be formed. For example, when the first electrode is prepared, an annealing process is performed on the first electrode, so that the deformation of the formed stress application layer is small. In this way, although the ferroelectric layer is likely to deform in the high-temperature environment, because the stress application layer is in contact with the ferroelectric layer, the stress application layer with the small deformation may be used to provide an in-plane tensile stress for the ferroelectric layer that is likely to deform, so that a lateral deformation of the ferroelectric layer is reduced. Further, the stress application layer further extends to between the second electrode and the dielectric layer that are adjacent to each other. In this way, on the basis of providing a tensile stress for the ferroelectric layer by the second electrode, the stress application layer may be further used to provide a longitudinal tensile stress for the ferroelectric layer, to reduce a longitudinal deformation of the ferroelectric layer. In other words, the stress application layer with a small coefficient of thermal expansion may generate a large tensile stress in a cooling process. The tensile stress may suppress formation of a dielectric M phase and increase a proportion of a ferroelectric O phase, to effectively suppress a volume change of the ferroelectric layer due to a phase change, thereby effectively improving ferroelectric performance.

Based on this, because the coefficient of thermal expansion of the stress application layer is smaller than that of the dielectric layer, and an overall tensile stress applied by the stress application layer and the second electrode to the ferroelectric layer are increased, a high annealing temperature is not required to compensate for an insufficient stress. Therefore, in a process of preparing the stress application layer, a temperature required for performing high-temperature annealing on the stress application layer is low, so that a thermal budget can be reduced. In comparison with a related technology, in this application, when the high-temperature annealing process is performed on the stress application layer, less damage is caused to the ferroelectric layer.

In some possible implementations, the coefficient of thermal expansion of the stress application layer is less than a coefficient of thermal expansion of the second electrode, to provide a larger tensile stress for the ferroelectric layer by using the stress application layer on the basis of providing the tensile stress for the ferroelectric layer by the second electrode. For example, a material of the stress application layer includes at least one of silicon dioxide, quartz, graphite, hexagonal boron nitride, silicon nitride, silicon, silicon germanium, and silicon carbide.

According to a third aspect, this application provides a preparation method for a chip, including: forming, on a substrate, a stress application layer made of a dielectric material, and a first electrode, a ferroelectric layer, and a second electrode that are stacked. A surface that is of the ferroelectric layer and that faces the second electrode is a first surface, the second electrode covers a part of the first surface, and a part that is of the first surface and that is not covered by the second electrode is a first subsurface. The chip further includes a stress application layer made of a dielectric material, a coefficient of thermal expansion of the stress application layer is less than a coefficient of thermal expansion of the second electrode, and the stress application layer extends from the first subsurface to a side wall of the second electrode.

In some possible implementations, before forming the stress application layer on the substrate, forming the first electrode, the ferroelectric layer, and the second electrode that are stacked includes: sequentially forming, on the substrate, the first electrode, the ferroelectric layer, and a conductive film layer (the following second conductive film layer) that are stacked; and etching the second conductive film layer to obtain the second electrode.

In some possible implementations, before forming the first electrode, the preparation method for the chip further includes: forming, on the substrate, a plurality of dielectric layers that are spaced apart and a plurality of stress application layers that are spaced apart. The stress application layer covers a side wall of the dielectric layer and a surface that is of the dielectric layer and that faces away from the substrate, and the coefficient of thermal expansion of the stress application layer is less than a coefficient of thermal expansion of the first electrode. Forming the first electrode includes: performing filling between adjacent stress application layers with the first electrode.

The third aspect and any implementation of the third aspect respectively correspond to the first aspect and any implementation of the first aspect. For technical effects corresponding to the third aspect and any implementation of the third aspect, refer to the technical effects corresponding to the first aspect and any implementation of the first aspect. Details are not described herein again.

According to a fourth aspect, this application provides a preparation method for a chip, including: forming, on a substrate, a plurality of dielectric layers and a plurality of sacrificial layers that are alternately stacked; forming a hollow portion in the plurality of dielectric layers and the plurality of sacrificial layers, where the hollow portion penetrates the plurality of dielectric layers and the plurality of sacrificial layers in a direction from the substrate to the second electrode; sequentially filling the hollow portion with a ferroelectric layer and a first electrode, where the ferroelectric layer is located between the first electrode, and the plurality of dielectric layers and the plurality of sacrificial layers; and removing the plurality of sacrificial layers to form a spacing region, and sequentially forming a stress application layer and a plurality of second electrodes in the spacing region, where a coefficient of thermal expansion of the stress application layer is less than a coefficient of thermal expansion of the dielectric layer, and the stress application layer extends from between the second electrode and the dielectric layer that are adjacent to each other to between the second electrode and the ferroelectric layer.

In some possible implementations, forming the stress application layer in the spacing region includes: forming the stress application layer by using a plasma enhanced chemical vapor deposition process or an atomic layer deposition process.

The fourth aspect and any implementation of the fourth aspect respectively correspond to the second aspect and any implementation of the second aspect. For technical effects corresponding to the fourth aspect and any implementation of the fourth aspect, refer to the technical effects corresponding to the second aspect and any implementation of the second aspect. Details are not described herein again.

According to a fifth aspect, this application provides an electronic device. The electronic device includes a circuit board and the chip according to the first aspect or the second aspect, and the chip is disposed on the circuit board.

The fifth aspect and any implementation of the fifth aspect respectively correspond to the first aspect, any implementation of the first aspect, the second aspect, and any implementation of the second aspect. For technical effects corresponding to the fifth aspect and any implementation of the fifth aspect, refer to the technical effects corresponding to the first aspect, the second aspect, any implementation of the first aspect, and any implementation of the second aspect. Details are not described herein again.

### BRIEF DESCRIPTION OF DRAWINGS

FIG. 1 is a block diagram of a connection between a processor and a memory in an electronic device according to an embodiment of this application;
FIG. 2 is a diagram of a structure of a ferroelectric capacitor according to an embodiment of this application;
FIG. 3a is a diagram of a working principle of a ferroelectric capacitor according to an embodiment of this application;
FIG. 3b is a diagram of a working principle of a ferroelectric capacitor according to an embodiment of this application;
FIG. 4 is a diagram of a structure of a ferroelectric capacitor according to an embodiment of this application;
FIG. 5a is a diagram of a structure of a ferroelectric capacitor and a stress application layer according to an embodiment of this application;
FIG. 5b is a diagram of a structure of a ferroelectric capacitor and a stress application layer according to an embodiment of this application;
FIG. 6 is a diagram of a structure of a ferroelectric capacitor and a stress application layer according to an embodiment of this application;
FIG. 7 is a diagram of a structure of a ferroelectric capacitor and a stress application layer according to an embodiment of this application;
FIG. 8 is a diagram of a structure of a ferroelectric capacitor and a stress application layer according to an embodiment of this application;
FIG. 9 is a diagram of a structure of a ferroelectric capacitor and a stress application layer according to an embodiment of this application;
FIG. 10a is a diagram of a preparation process of a two-dimensional ferroelectric capacitor according to an embodiment of this application;
FIG. 10b is a diagram of a preparation process of a two-dimensional ferroelectric capacitor according to an embodiment of this application;
FIG. 10c is a diagram of a preparation process of a two-dimensional ferroelectric capacitor according to an embodiment of this application;
FIG. 11a is a diagram of a preparation process of a two-dimensional ferroelectric capacitor according to an embodiment of this application;
FIG. 11b is a diagram of a preparation process of a two-dimensional ferroelectric capacitor according to an embodiment of this application;
FIG. 11c is a diagram of a preparation process of a two-dimensional ferroelectric capacitor according to an embodiment of this application;
FIG. 12 is a diagram of a structure of a three-dimensional ferroelectric capacitor and a stress application layer according to an embodiment of this application;
FIG. 13 is a diagram of a structure of a three-dimensional ferroelectric capacitor and a stress application layer according to an embodiment of this application;
FIG. 14 is a diagram of a structure of a three-dimensional ferroelectric capacitor and a stress application layer according to an embodiment of this application;
FIG. 15 is a flowchart of preparing a three-dimensional ferroelectric capacitor and a stress application layer according to an embodiment of this application;
FIG. 16a is a diagram of a preparation process of a three-dimensional ferroelectric capacitor and a stress application layer according to an embodiment of this application;
FIG. 16b is a diagram of a preparation process of a three-dimensional ferroelectric capacitor and a stress application layer according to an embodiment of this application;
FIG. 16c is a diagram of a preparation process of a three-dimensional ferroelectric capacitor and a stress application layer according to an embodiment of this application; and
FIG. 16d is a diagram of a preparation process of a three-dimensional ferroelectric capacitor and a stress application layer according to an embodiment of this application.

### Reference numerals:

10: substrate; 11: first electrode; 111: first conductive film layer; 12: second electrode; 121: first sub-electrode; 122: second sub-electrode; 1211: second conductive film layer; 13: ferroelectric layer; 14: stress application layer; 15: dielectric layer; 16: sacrificial layer.

### DESCRIPTION OF EMBODIMENTS

The following clearly and completely describes the technical solutions in embodiments of this application with reference to accompanying drawings in embodiments of this application. It is clear that the described embodiments are a part but not all of embodiments of this application. All other embodiments obtained by a person of ordinary skill in the art based on embodiments of this application without creative efforts shall fall within the protection scope of this application.

The term "and/or" in this specification describes only an association relationship for describing associated objects and indicates that three relationships may exist. For example, A and/or B may indicate the following three cases: Only A exists, both A and B exist, and only B exists.

In the specification and claims in embodiments of this application, the terms "first", "second", and the like are intended to distinguish between different objects but do not indicate a specific order of the objects. For example, a first target object, a second target object, and the like are used to distinguish between different target objects, but are not used to describe a specific order of the target objects.

In embodiments of this application, the term "example", "for example", or the like indicates giving an example, an illustration, or a description. Any embodiment or design scheme described as an "example" or "for example" in embodiments of this application should not be explained as being more preferred or having more advantages than another embodiment or design scheme. To be precise, use of the term "example", "for example", or the like is intended to present a related concept in a specific manner.

In descriptions of embodiments of this application, unless otherwise stated, "a plurality of" means two or more. For example, a plurality of processing units are two or more processing units, and a plurality of systems are two or more systems.

An embodiment of this application provides an electronic device. The electronic device may be a device including a ferroelectric capacitor, for example, a consumer electronic product, a home electronic product, a vehicle-mounted electronic product, a financial terminal product, or a communication electronic product.

For example, the consumer electronic product is a mobile phone (mobile phone), a tablet computer (tablet computer), a notebook computer, a personal computer (personal computer, PC), a personal digital assistant (personal digital assistant, PDA), an intelligent wearable product (for example, a smartwatch or a smart band), a virtual reality (virtual reality, VR) terminal device, an augmented reality (augmented reality, AR) terminal device, or an unmanned aerial vehicle. For example, the home electronic product is a smart door lock, a television, a smart speaker, a refrigerator, and a robotic vacuum cleaner. For example, the vehicle-mounted electronic product is a vehicle-mounted navigator or a vehicle-mounted display. For example, the financial terminal product is an automated teller machine (automated teller machine, ATM) or a self-service transaction terminal. For example, the communication electronic product is a device including a chip, for example, a communication device like a server, a memory, a radar, or a base station.

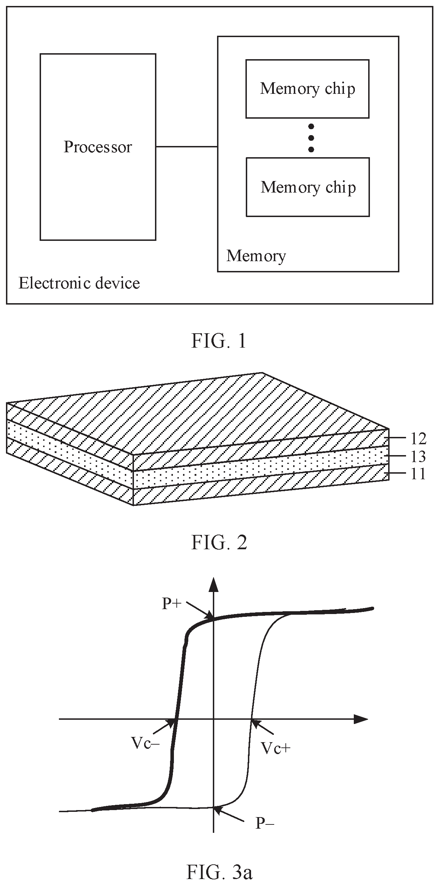

For ease of description, the following uses an example in which the electronic device is a mobile phone for description. As shown in FIG. 1, the mobile phone may include a circuit board. A processor, a memory, and the like may be integrated on the circuit board. The memory includes a plurality of memory chips. Certainly, the mobile phone may further include another component, and another circuit structure may be further integrated on the circuit board. This is not limited in embodiments of this application.

The processor may read data from and write data into the memory. For example, a memory in the mobile phone may be configured to store computer-executable program code. The executable program code includes instructions. The processor runs the instructions stored in the memory, to perform various function applications and data processing of the mobile phone.

In recent years, technologies such as big data and artificial intelligence have entered a golden era of rapid development. The advancement of these emerging technologies is driving fundamental changes in human lifestyles, modes of production, and ways of thinking. In addition, the application and integration of new technologies cannot be implemented without collection, transmission, and computation of massive data as support. As a result, an amount of information data that needs to be processed gradually experiences an explosive surge, imposing a higher requirement on performance of the memory.

For the memory, the performance of the memory needs to be evaluated in terms of a plurality of aspects such as a storage capacity, a read/write speed, non-volatility, and an integration capability. An existing dynamic random access memory (dynamic random access memory, DRAM) and an existing static random access memory (static random access memory, SRAM) have a high read/write speed, but the DRAM needs to be continuously refreshed during use, resulting in high power consumption. In addition, the two memories have disadvantages of high costs, limited capacity, and data volatility during application, and scaling processes of the two memories are approaching physical limits. A non-volatile memory represented by a NAND flash (NAND flash memory) has an advantage of large storage capacity, but has a low read/write speed, and cannot meet an application requirement of high-speed storage. In this case, it is urgent to find a computing-in-memory memory with a high read/write speed, non-volatility, low power consumption, and scalability, to improve a computing capability of a chip, reduce a chip area, and further reduce chip costs.

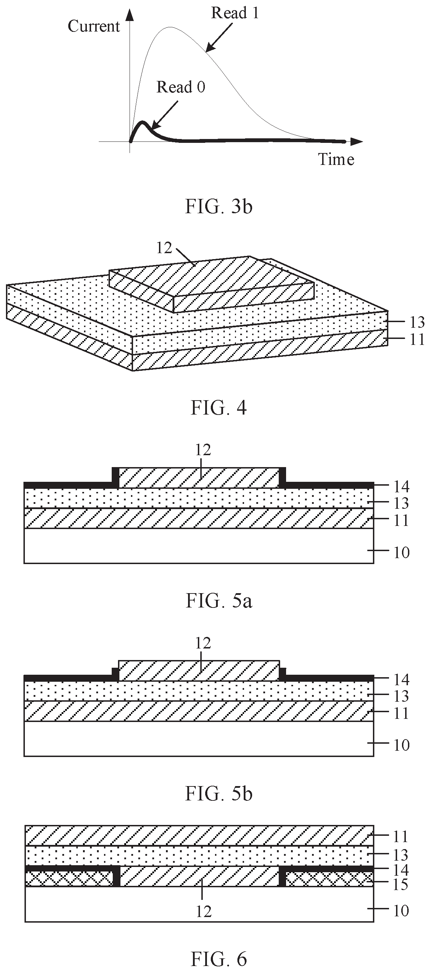

Ferroelectric random access memories (ferroelectric random access memories, FeRAMs) have gradually become one of the most potential memories in a next-generation storage technology by virtue of features such as high read/write speed, non-volatility, low power consumption, low component size, and good endurance. As shown in FIG. 2, a core part of a ferroelectric memory includes a ferroelectric capacitor. The ferroelectric capacitor includes a first electrode 11, a ferroelectric layer 13, and a second electrode 12 that are sequentially stacked. As shown in FIG. 3a and FIG. 3b, polarization switching occurs on the ferroelectric layer under electric fields of different directions, causing charging and discharging of the capacitor, thereby achieving a storage state of "0" or "1".

Performance of the ferroelectric layer is affected by a plurality of factors, for example, a doping element of the ferroelectric layer, a thickness of the ferroelectric layer, an oxygen vacancy in the ferroelectric layer, and a material of the first electrode 11 and a material of the second electrode 12. Coefficients of thermal expansion of the material of the first electrode and the material of the second electrode have great impact on remnant polarization Pr of the ferroelectric layer. If the coefficients of thermal expansion of the first electrode 11 and the second electrode 12 are excessively large, it is not conducive to formation of a ferroelectric O phase of the ferroelectric layer. In addition, it is prone to a phase change (a change from an O phase to an M phase) of the ferroelectric layer 13. When the phase change occurs on the ferroelectric layer 13, a volume change of the ferroelectric layer 13 cannot be suppressed. As a result, ferroelectric performance cannot be effectively improved. In this case, a high annealing temperature is required to compensate for an insufficient stress. This is prone to damaging the ferroelectric layer 13 during annealing.

A larger ferroelectric O phase of the ferroelectric layer 13 indicates better ferroelectric performance of the ferroelectric layer 13, and a larger dielectric M phase (ferroelectric monoclinic phase) of the ferroelectric layer 13 indicates poorer ferroelectric performance of the ferroelectric layer 13.

In view of this, a related technology proposes that a metal with a low coefficient of thermal expansion is used as the material of the first electrode 11 and the material of the second electrode 12. However, coefficients of thermal expansion of existing metal materials are not small enough, and the foregoing problems still exist.

Based on this, an embodiment of this application provides a chip. The chip includes a substrate and a ferroelectric capacitor disposed on the substrate. As shown in FIG. 4, the ferroelectric capacitor includes a first electrode 11, a ferroelectric layer 13, and a second electrode 12 that are sequentially stacked on the substrate. A surface that is of the ferroelectric layer 13 and that faces the second electrode 12 is a first surface, the second electrode 12 covers a part of the first surface, and a part that is of the first surface and that is not covered by the second electrode 12 is a first subsurface.

Based on this, as shown in FIG. 5a, FIG. 5b, and FIG. 6, the chip further includes a stress application layer 14 made of a dielectric material, a coefficient of thermal expansion of the stress application layer 14 is less than a coefficient of thermal expansion of the second electrode 12, and the stress application layer 14 extends from the first subsurface to a side wall of the second electrode 12.

In this application, a size of the second electrode 12 is reduced, to cover the stress application layer 14 on the first subsurface. The coefficient of thermal expansion of the stress application layer 14 is less than the coefficient of thermal expansion of the second electrode 12. Therefore, in a high-temperature environment, a deformation of the stress application layer 14 is less than a deformation of the second electrode 12, and a stronger chemical bond can be formed. For example, when the stress application layer 14 and the second electrode 12 are prepared, an annealing process is performed on the stress application layer 14 and the second electrode 12 separately. The deformation of the stress application layer 14 is less than the deformation of the second electrode 12. In this way, although the ferroelectric layer 13 is likely to deform in the high-temperature environment, because the stress application layer 14 is in contact with the first subsurface, the stress application layer 14 with a small deformation may be used to provide an in-plane tensile stress for the ferroelectric layer 13 that is likely to deform, so that a lateral deformation of the ferroelectric layer 13 is reduced. Further, the stress application layer 14 further extends to the side wall of the second electrode 12. In this case, the stress application layer 14 may be further used to provide a longitudinal tensile stress for the ferroelectric layer 13, so that a longitudinal deformation of the ferroelectric layer is reduced. In other words, the stress application layer 14 with a small coefficient of thermal expansion may generate a large tensile stress in a cooling process. The tensile stress may suppress formation of a dielectric M phase and increase a proportion of a ferroelectric O phase, to effectively suppress a volume change of the ferroelectric layer 13 due to a phase change, thereby effectively improving ferroelectric performance.

Based on this, because the coefficient of thermal expansion of the stress application layer 14 is smaller than that of the second electrode 12, and an overall tensile stress applied by the stress application layer 14 and the second electrode 12 to the ferroelectric layer 13 are increased, a high annealing temperature is not required to compensate for an insufficient stress. Therefore, in a process of preparing the stress application layer 14, a temperature required for performing high-temperature annealing on the stress application layer 14 is low, so that a thermal budget can be reduced. In comparison with a related technology, in this application, when a high-temperature annealing process is performed on the stress application layer 14, less damage is caused to the ferroelectric layer 13.

"Longitudinal" in the longitudinal tensile stress means a direction from the first electrode 11 to the second electrode 12. "Horizontal" in a horizontal tensile stress means a direction perpendicular to a longitudinal direction.

In some possible implementations, as shown in FIG. 5a, the stress application layer 14 may completely cover the first subsurface, to provide the in-plane tensile stress for the ferroelectric layer 13 to a maximum extent, and reduce a lateral deformation of a part that is of the ferroelectric layer 13 and that is in contact with the stress application layer 14.

In some possible implementations, based on different processes, as shown in FIG. 5a, the stress application layer 14 may completely cover the side wall of the second electrode 12; or as shown in FIG. 5b, the stress application layer 14 may alternatively partially cover the side wall of the second electrode 12.

In some possible implementations, as shown in FIG. 5a and FIG. 5b, the first electrode 11, the ferroelectric layer 13, and the second electrode 12 may be sequentially stacked on the substrate 10 in a direction from the substrate 10 to the ferroelectric capacitor. In this case, the first electrode 11 is a bottom electrode, and the second electrode 12 is a top electrode.

Alternatively, as shown in FIG. 6, the first electrode 11, the ferroelectric layer 13, and the second electrode 12 may be sequentially stacked on the substrate 10 in a direction from the ferroelectric capacitor to the substrate 10. In this case, the first electrode 11 is a top electrode, and the second electrode 12 is a bottom electrode.

In some possible implementations, the stress application layer 14 encircles the second electrode 12, or in other words, the first subsurface encircles the second electrode 12 (FIG. 4), to provide a larger stress for an entire edge of the ferroelectric layer 13 by using the stress application layer 14. Alternatively, the stress application layer 14 does not encircle the second electrode 12, provided that the first surface of the ferroelectric layer 13 is not completely covered by the second electrode 12.

In some possible implementations, a material of the ferroelectric layer 13 is not limited in embodiments of this application. The material of the ferroelectric layer 13 may include a ferroelectric material, or may include an anti-ferroelectric material.

For example, the material of the ferroelectric layer 13 may include a perovskite ferroelectric material. For example, the material of the ferroelectric layer 13 includes lead titanate (PbTiO₃).

For example, the material of the ferroelectric layer 13 may alternatively include a hafnium oxide-based ferroelectric material. For example, the material of the ferroelectric layer 13 includes hafnium oxide and hafnium zirconium oxide.

Because the perovskite ferroelectric material has a small band gap, a leakage current is large, and a size of the ferroelectric layer 13 cannot be scaled down. In addition, because a temperature required for preparation is high, and a part of film layers in a transistor on the chip are likely to be affected by the high temperature, the ferroelectric capacitor cannot be compatible with the transistor. The hafnium oxide-based ferroelectric material has a large band gap, a small leakage current, low power consumption, and good endurance, the size of the ferroelectric layer 13 can be scaled down (for example, the ferroelectric layer 13 is still ferroelectric when a thickness is reduced to less than 10 nm), and a preparation process can be compatible with the transistor. These characteristics provide the ferroelectric capacitor with unique advantages in constructing a high-density memory chip. Therefore, optionally, the material of the ferroelectric layer 13 includes the hafnium oxide-based ferroelectric material.

In some possible implementations, a material of the first electrode 11 and a material of the second electrode 12 are not limited in embodiments of this application, provided that the first electrode 11 and the second electrode 12 are conductive.

Table 1 shows coefficients of thermal expansion of several conductive materials. It can be learned from Table 1 that coefficients of thermal expansion of tungsten (W), molybdenum (Mo), platinum (Pt), titanium nitride (TiN), nickel (Ni), and copper (Cu) gradually increase. Optionally, a conductive material with a small coefficient of thermal expansion may be selected as the material of the first electrode 11 and the material of the second electrode 12. For example, the material of the first electrode 11 and the material of the second electrode 12 may include W. In this way, the first electrode 11 and the second electrode 12 may also provide a specific degree of in-plane tensile stress for the ferroelectric layer 13, to improve a lateral deformation of a part that is of the ferroelectric layer 13 and that is in contact with the first electrode 11 and the second electrode 12. In addition, a thermal budget for forming the first electrode 11 and the second electrode 12 may be further reduced, to avoid damage to the ferroelectric layer 13 caused by high-temperature annealing in a process of preparing the first electrode 11 and the second electrode 12.

**Table 1**

| Material | Coefficient of thermal expansion (10⁻⁶/K) |
|---|---|
| W | 4.5 |
| Mo | 5.2 |
| Pt | 9.0 |
| TiN | 9.35 |
| Ni | 13.0 |
| Cu | 16.5 |

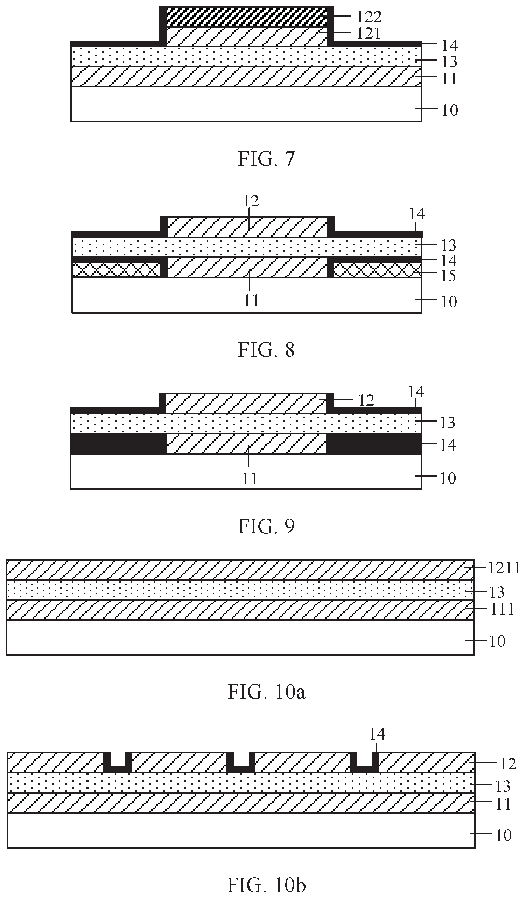

It is considered that, in some cases, a top electrode including W cannot directly grow on the ferroelectric layer 13, for example, the top electrode is the second electrode 12. In this case, as shown in FIG. 7, the second electrode 12 may include a first sub-electrode 121 and a second sub-electrode 122, and the first sub-electrode 121 is disposed between the ferroelectric layer 13 and the second sub-electrode 122. A material of the first sub-electrode 121 includes a material that can directly grow on the ferroelectric layer 13 (for example, TiN), and a material of the second sub-electrode 122 includes W.

In some possible implementations, a material of the stress application layer 14 is not limited in embodiments of this application, provided that a coefficient of thermal expansion of the material of the stress application layer 14 is less than a coefficient of thermal expansion of the material of the second electrode 12.

Table 2 shows coefficients of thermal expansion of some materials. It can be learned from Table 2 that coefficients of thermal expansion of silicon dioxide (SiO₂), quartz (Quartz), graphite (Graphite), hexagonal boron nitride (h-BN), silicon nitride (SiN), silicon (Si), silicon germanium (SiGe), and silicon carbide (SiC) gradually increase. Optionally, a dielectric material with a small coefficient of thermal expansion may be selected as the material of the stress application layer 14. For example, the coefficient of thermal expansion of the material of the stress application layer 14 is less than a coefficient of thermal expansion of W, and the material of the stress application layer 14 may include at least one of SiO₂, quartz, graphite, h-BN, SiN, Si, SiGe, and SiC, so that a tensile stress provided by the stress application layer 14 for the ferroelectric layer 13 exceeds 1 GPa. For example, the material of the stress application layer 14 includes SiN. The tensile stress provided by the stress application layer 14 for the ferroelectric layer 13 may exceed 1.7 GPa.

**Table 2**

| Material | Coefficient of thermal expansion (10⁻⁶/K) |
|---|---|
| SiO2 | 0.5 |
| Quartz | 0.55 |
| Graphite | 2.0 |
| h-BN | 2.0 |
| SiN | 2.45 |
| Si | 2.5 |
| SiGe | 3.4 |
| SiC | 4.0 |

In some possible implementations, after a SiO₂ film layer, a quartz film layer, a graphite film layer, an h-BN film layer, a Si film layer, a SiGe film layer, and a SiC film layer are deposited, the SiO₂ film layer, the quartz film layer, the graphite film layer, the h-BN film layer, a SiN film layer, the Si film layer, the SiGe film layer, and the SiC film layer may be processed by using the high-temperature annealing process.

For the SiN film layer, the SiN film layer may be processed by using the high-temperature annealing process, or the SiN film layer may be processed by using an ultraviolet curing process.

In some embodiments, as shown in FIG. 8, a surface that is of the ferroelectric layer 13 and that faces the first electrode 11 is a second surface, the first electrode 11 covers a part of the second surface, and a part that is of the second surface and that is not covered by the first electrode 11 is a second subsurface. The coefficient of thermal expansion of the stress application layer 14 is less than a coefficient of thermal expansion of the first electrode 11, and the stress application layer 14 further extends from the second subsurface to a side wall of the first electrode 11. In addition, a dielectric layer 15 may be further disposed between the stress application layer 14 and the substrate 10.

A size of the first electrode 11 is reduced, to cover the stress application layer 14 on the second subsurface. The coefficient of thermal expansion of the stress application layer 14 is less than the coefficient of thermal expansion of the first electrode 11. Therefore, in the high-temperature environment, the deformation of the stress application layer 14 is less than a deformation of the first electrode 11, and a stronger chemical bond can be formed. For example, when the stress application layer 14 and the first electrode 11 are prepared, an annealing process is performed on the stress application layer 14 and the first electrode 11 separately. The deformation of the stress application layer 14 is less than the deformation of the first electrode 11. In this way, although the ferroelectric layer 13 is likely to deform in the high-temperature environment, because the stress application layer 14 is in contact with the second subsurface, the stress application layer 14 with the small deformation may be used to provide an in-plane tensile stress for the ferroelectric layer 13 that is likely to deform, so that the lateral deformation of the ferroelectric layer 13 is reduced. Further, the stress application layer 14 further extends to the side wall of the first electrode 11. In this case, the stress application layer 14 may be further used to provide a longitudinal tensile stress for the ferroelectric layer 13, so that the longitudinal deformation of the ferroelectric layer is reduced. In other words, the stress application layer 14 with the small coefficient of thermal expansion may generate a large tensile stress in the cooling process. The tensile stress may suppress formation of the dielectric M phase and increase the proportion of the ferroelectric O phase, to effectively suppress the volume change of the ferroelectric layer due to the phase change, thereby effectively improving the ferroelectric performance.

Based on this, because the coefficient of thermal expansion of the stress application layer 14 is smaller than that of the first electrode 11, and the overall tensile stress applied by the stress application layer 14 and the second electrode 12 to the ferroelectric layer 13 are increased, the high annealing temperature is not required to compensate for the insufficient stress. Therefore, in the process of preparing the stress application layer 14, the temperature required for performing high-temperature annealing on the stress application layer 14 is low, so that the thermal budget can be reduced. In comparison with the related technology, in this application, when the high-temperature annealing process is performed on the stress application layer 14, less damage is caused to the ferroelectric layer 13.

In addition, in some embodiments, as shown in FIG. 9, when the ferroelectric layer 13 includes the second subsurface that is not covered by the first electrode 11, the stress application layer 14 may be further completely filled between the substrate 10 and the ferroelectric layer 13 and disposed adjacent to the first electrode 11, to make use of a lateral tensile stress provided by the stress application layer 14.

In another embodiment, an embodiment of this application further provides a preparation method for a chip, which may be classified into the following several cases.

In a first case, it is assumed that a first electrode 11 is a bottom electrode, a second electrode 12 is a top electrode, and a stress application layer 14 is formed on a side that is of a ferroelectric layer 13 and that faces the second electrode 12.

Specifically, a process of preparing the chip includes the following steps. As shown in FIG. 10a, a first conductive film layer 111 (that is, the first electrode), the ferroelectric layer 13, and a second conductive film layer 1211 that are stacked are sequentially formed on the substrate 10. As shown in FIG. 10b, the second conductive film layer 1211 is etched to obtain the second electrode 12. A surface that is of the ferroelectric layer 13 and that faces the second electrode 12 is a first surface, the second electrode 12 covers a part of the first surface, and a part that is of the first surface and that is not covered by the second electrode 12 is a first subsurface.

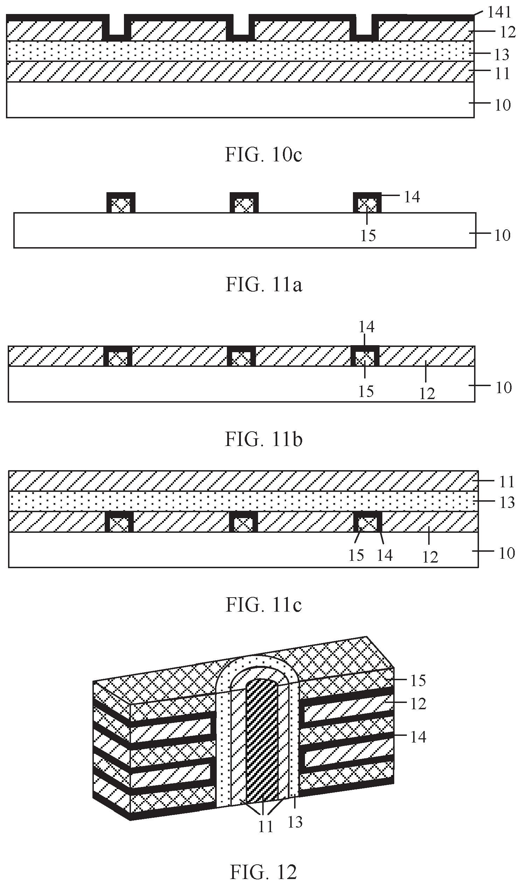

Then, as shown in FIG. 10c, a stress application film layer 141 is formed on the second electrode 12, and a part that is of the stress application film layer 141 and that is on a side facing away from the substrate 10 is removed, to expose a surface that is of the second electrode 12 and that is on the side facing away from the substrate 10, so that the second electrode is electrically connected to a conductive lead to transmit a signal. A coefficient of thermal expansion of the stress application layer 14 is less than a coefficient of thermal expansion of the second electrode 12, and the stress application layer 14 extends from the first subsurface to a side wall of the second electrode 12. For example, the part that is of the stress application film layer 141 and that is on the side facing away from the substrate 10 may be removed through chemical machinery (chemical mechanical polishing, CMP).

In a second case, it is assumed that a first electrode 11 is a top electrode, a second electrode 12 is a bottom electrode, and a stress application layer 14 is formed on a side that is of a ferroelectric layer 13 and that faces the second electrode 12.

Specifically, a process of preparing the chip includes the following steps. As shown in FIG. 11a, a dielectric layer 15 and the stress application layer 14 are sequentially formed on a substrate 10. A plurality of dielectric layers 15 are spaced apart, and the stress application layer 14 covers a side wall of the dielectric layer 15 and a surface that is of the dielectric layer 15 and that is on a side facing away from the substrate 10. Then, as shown in FIG. 11b, filling is performed between adjacent stress application layers 14 with the second electrode 12. In this way, the stress application layer 14 can cover a side wall of the second electrode 12. A coefficient of thermal expansion of the stress application layer 14 is less than a coefficient of thermal expansion of the second electrode 12.

Then, as shown in FIG. 11c, the ferroelectric layer 13 and the first electrode 11 are sequentially formed on the stress application layer 14 and the second electrode 11. A surface that is of the ferroelectric layer 13 and that faces the second electrode 12 is a first surface, the second electrode 12 covers a part of the first surface, and a part that is of the first surface and that is not covered by the second electrode 12 is a first subsurface, so that the stress application layer 14 covers the first subsurface.

In some other possible implementations, the second electrode 12 may alternatively be first formed, and then the dielectric layer 15 and the stress application layer 14 are formed. This is not limited in embodiments of this application.

In a third case, it is assumed that a first electrode 11 is a bottom electrode, a second electrode 12 is a top electrode, and a stress application layer 14 is formed on a side that is of a ferroelectric layer 13 and that faces the second electrode 12 and a side that is of the ferroelectric layer 13 and that faces the first electrode 11.

Specifically, a process of preparing the chip includes the following steps. As shown in FIG. 11a, a dielectric layer 15 and the stress application layer 14 are sequentially formed on a substrate 10. A plurality of dielectric layers 15 are spaced apart, and the stress application layer 14 covers a side wall of the dielectric layer 15 and a surface that is of the dielectric layer 15 and that is on a side facing away from the substrate 10. Then, as shown in FIG. 11b, filling is performed between adjacent stress application layers 14 with the first electrode 11. In this way, the stress application layer 14 can cover a side wall of the first electrode 11. A coefficient of thermal expansion of the stress application layer 14 is less than a coefficient of thermal expansion of the first electrode 11.

Then, with reference to FIG. 11c, the ferroelectric layer 13 and a second conductive film layer 1211 are sequentially formed on the stress application layer 14 and the first electrode 11. A surface that is of the ferroelectric layer 13 and that faces the first electrode 11 is a second surface, the first electrode 11 covers a part of the second surface, and a part that is of the second surface and that is not covered by the first electrode 11 is a second subsurface, so that the stress application layer 14 covers the second subsurface.

Then, with reference to FIG. 10b, the second conductive film layer 1211 is etched to obtain the second electrode 12. A surface that is of the ferroelectric layer 13 and that faces the second electrode 12 is a first surface, the second electrode 12 covers a part of the first surface, and a part that is of the first surface and that is not covered by the second electrode 12 is a first subsurface.

Then, as shown in FIG. 8, a stress application film layer 141 is formed on the second electrode 12, and a part that is of the stress application film layer 141 and that is on a side facing away from the substrate 10 is removed to obtain the stress application layer 14, to expose a surface that is of the second electrode 12 and that is on the side facing away from the substrate 10, so that the second electrode is electrically connected to a conductive lead to transmit a signal. The coefficient of thermal expansion of the stress application layer 14 is less than a coefficient of thermal expansion of the second electrode 12, and the stress application layer 14 extends from the first subsurface to a side wall of the second electrode 12. For example, the part that is of the stress application film layer 141 and that is on the side facing away from the substrate 10 may be removed through CMP.

In some possible implementations, for the foregoing three cases, after the stress application film layer 141 is deposited or the stress application layer 14 is deposited, a tensile stress of the stress application film layer 141 or the stress application layer 14 (a maximum tensile stress may reach 1.7 GPa) may be further increased by using an annealing process. In some possible implementations, for the foregoing three cases, processes of depositing the first conductive film layer (or the first electrode) 111, the ferroelectric layer 13, the second conductive film layer (or the second electrode) 1211, and the stress application film layer 141 are not limited in embodiments of this application.

Optionally, the bottom electrode may be deposited by using a physical vapor deposition (physical vapor deposition, PVD) process. The bottom electrode may be the first conductive film layer (or the first electrode) 111 or the second conductive film layer (or the second electrode) 1211.

The ferroelectric layer 13 may be deposited by using a plasma enhanced chemical vapor deposition (plasma enhanced chemical vapor deposition, PECVD) process or an atomic layer deposition (atomic layer deposition, ALD) process.

The top electrode may be deposited by using a chemical vapor deposition (chemical vapor deposition, CVD) process. The top electrode may be the second conductive film layer (or the second electrode) 1211 or the first conductive film layer (or the first electrode) 111.

The stress application film layer 141 may be deposited by using the plasma enhanced chemical vapor deposition (plasma enhanced chemical vapor deposition) or the ALD process.

In addition, other explanations, descriptions, and beneficial effects of embodiments of this application are the same as those of the previous embodiment. Details are not described herein again.

The foregoing two embodiments respectively describe a structure of a two-dimensional ferroelectric capacitor and a preparation method for the two-dimensional ferroelectric capacitor. In some other embodiments, a ferroelectric capacitor may alternatively be a three-dimensional ferroelectric capacitor.

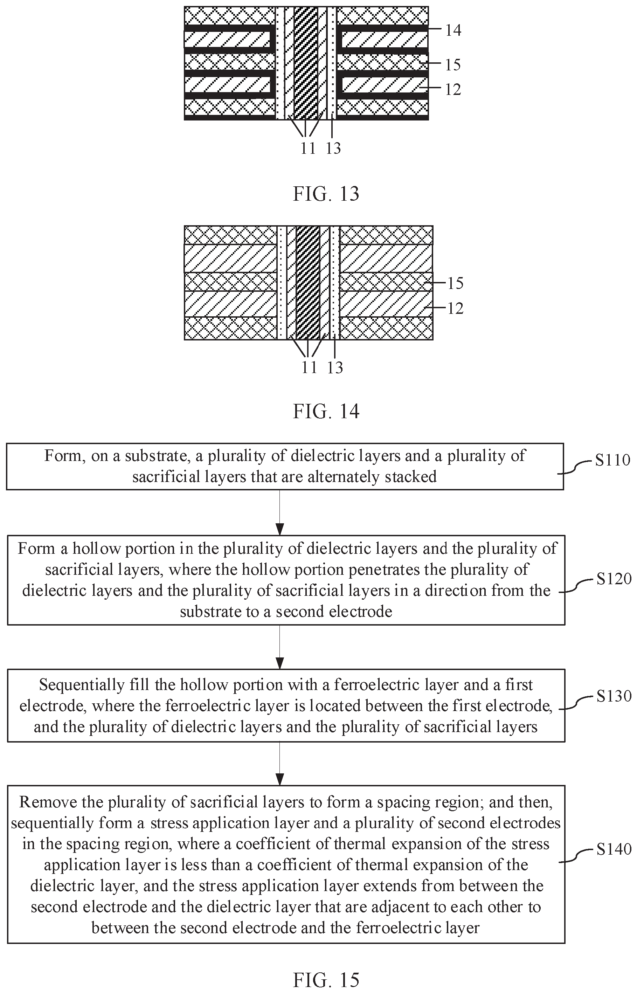

Specifically, as shown in FIG. 12 and FIG. 13, a chip includes a three-dimensional ferroelectric capacitor disposed on a substrate 10. The three-dimensional ferroelectric capacitor includes a first electrode 11, a ferroelectric layer 13, a plurality of second electrodes 12, and a plurality of dielectric layers 15. In a direction from the substrate 10 to the three-dimensional capacitor, the plurality of second electrodes 12 and the plurality of dielectric layers 15 are alternately disposed, the ferroelectric layer 13 and the first electrode 11 penetrates the plurality of second electrodes 12 and the plurality of dielectric layers 15, and the ferroelectric layer 13 is disposed between the plurality of second electrodes 12 and the first electrode 11.

Based on this, the chip further includes a stress application layer 14 made of a dielectric material, a coefficient of thermal expansion of the stress application layer 14 is less than a coefficient of thermal expansion of the dielectric layer 15, and the stress application layer 14 extends from between the second electrode 12 and the dielectric layer 15 that are adjacent to each other to between the second electrode 12 and the ferroelectric layer 13. In FIG. 12 and FIG. 13, a part of the three-dimensional capacitor is shown as an example.

In this application, the coefficient of thermal expansion of the stress application layer 14 is less than the coefficient of thermal expansion of the dielectric layer 15. Therefore, in a high-temperature environment, a deformation of the stress application layer 14 is less than a deformation of the dielectric layer 15, and a stronger chemical bond can be formed. For example, when the first electrode 11 is prepared, an annealing process is performed on the first electrode 11, so that the deformation of the formed stress application layer 14 is small. In this way, although the ferroelectric layer 13 is likely to deform in the high-temperature environment, because the stress application layer 14 is in contact with the ferroelectric layer 13, the stress application layer 14 with the small deformation may be used to provide an in-plane tensile stress for the ferroelectric layer 13 that is likely to deform, so that a lateral deformation of the ferroelectric layer 13 is reduced. Further, the stress application layer 14 further extends to between the second electrode 12 and the dielectric layer 15 that are adjacent to each other. In this way, on the basis of providing a tensile stress for the ferroelectric layer by the second electrode 12, the stress application layer 14 may be further used to provide a longitudinal tensile stress for the ferroelectric layer 13, to reduce a longitudinal deformation of the ferroelectric layer. In other words, the stress application layer 14 with a small coefficient of thermal expansion may generate a large tensile stress in a cooling process. The tensile stress may suppress formation of a dielectric M phase and increase a proportion of a ferroelectric O phase, to effectively suppress a volume change of the ferroelectric layer 13 due to a phase change, thereby effectively improving ferroelectric performance.

Based on this, because the coefficient of thermal expansion of the stress application layer 14 is smaller than that of the dielectric layer 15, and an overall tensile stress applied by the stress application layer 14 and the second electrode 12 to the ferroelectric layer 13 are increased, a high annealing temperature is not required to compensate for an insufficient stress. Therefore, in a process of preparing the stress application layer 14, a temperature required for performing high-temperature annealing on the stress application layer 14 is low, so that a thermal budget can be reduced. In comparison with a related technology, in this application, when the high-temperature annealing process is performed on the stress application layer 14, less damage is caused to the ferroelectric layer 13.

"Longitudinal" in the longitudinal tensile stress means a direction from the first electrode 11 to the second electrode 12. "Horizontal" in a horizontal tensile stress means a direction perpendicular to a longitudinal direction.

In some possible implementations, based on different processes, as shown in FIG. 12 and FIG. 13, the stress application layer 14 may completely cover a surface that is of the second electrode 12 and that faces the substrate 10 and a surface that is of the second electrode 12 and that faces away from the substrate 10, or the stress application layer 14 may partially cover a surface that is of the second electrode 12 and that faces the substrate 10 and a surface that is of the second electrode 12 and that faces away from the substrate 10.

In some possible implementations, a material of the ferroelectric layer 13 is not limited in embodiments of this application. The material of the ferroelectric layer 13 may include a ferroelectric material, or may include an anti-ferroelectric material.

For example, the material of the ferroelectric layer 13 may include a perovskite ferroelectric material. For example, the material of the ferroelectric layer 13 includes PbTiO₃.

For example, the material of the ferroelectric layer 13 may alternatively include a hafnium oxide-based ferroelectric material. For example, the material of the ferroelectric layer 13 includes hafnium oxide and hafnium zirconium oxide.

Because the perovskite ferroelectric material has a small band gap, a leakage current is large, and a size of the ferroelectric layer 13 cannot be scaled down. In addition, because a temperature required for preparation is high, and a part of film layers in a transistor on the chip are likely to be affected by the high temperature, the ferroelectric capacitor cannot be compatible with the transistor. The hafnium oxide-based ferroelectric material has a large band gap, a small leakage current, low power consumption, and good endurance, the size of the ferroelectric layer 13 can be scaled down (for example, the ferroelectric layer 13 is still ferroelectric when a thickness is reduced to less than 10 nm), and a preparation process can be compatible with the transistor. These characteristics provide the ferroelectric capacitor with unique advantages in constructing a high-density memory chip. Therefore, optionally, the material of the ferroelectric layer 13 includes the hafnium oxide-based ferroelectric material.

In some possible implementations, a material of the first electrode 11 and a material of the second electrode 12 are not limited in embodiments of this application, provided that the first electrode 11 and the second electrode 12 are conductive.

Table 1 shows coefficients of thermal expansion of several conductive materials. It can be learned from Table 1 that coefficients of thermal expansion of W, Mo, Pt, TiN, Ni, and Cu gradually increase. Optionally, a conductive material with a small coefficient of thermal expansion may be selected as the material of the first electrode 11 and the material of the second electrode 12. For example, the material of the first electrode 11 and the material of the second electrode 12 may include W. In this way, the first electrode 11 and the second electrode 12 may also provide a specific degree of in-plane tensile stress for the ferroelectric layer 13, to improve a lateral deformation of a part that is of the ferroelectric layer 13 and that is in contact with the first electrode 11 and the second electrode 12. In addition, a thermal budget for forming the first electrode 11 and the second electrode 12 may be further reduced, to avoid damage to the ferroelectric layer 13 caused by the high temperature in a process of preparing the first electrode 11 and the second electrode 12.

It is considered that, in some cases, the first electrode 11 including W cannot directly grow on the ferroelectric layer 13. In this case, as shown in FIG. 12, the first electrode 11 may include a third sub-electrode and a fourth sub-electrode, and the third sub-electrode is disposed between the ferroelectric layer 13 and the fourth sub-electrode. A material of the third sub-electrode includes a material that can directly grow on the ferroelectric layer 13 (for example, TiN), and a material of the fourth sub-electrode includes W.

In some possible implementations, a material of the stress application layer 14 is not limited in embodiments of this application, provided that a coefficient of thermal expansion of the material of the stress application layer 14 is less than a coefficient of thermal expansion of a material of the dielectric layer 15.

Table 2 shows coefficients of thermal expansion of some materials. It can be learned from Table 2 that coefficients of thermal expansion of SiO₂, quartz, graphite, h-BN, SiN, Si, SiGe, and SiC gradually increase. Optionally, a dielectric material with a small coefficient of thermal expansion may be selected as the material of the stress application layer 14. For example, the coefficient of thermal expansion of the material of the stress application layer 14 is less than a coefficient of thermal expansion of the second electrode 12, to provide a larger tensile stress for the ferroelectric layer 13 by using the stress application layer 14 on the basis of providing the tensile stress for the ferroelectric layer 13 by the second electrode 12.

For example, the coefficient of thermal expansion of the material of the stress application layer 14 is less than a coefficient of thermal expansion of W, and the material of the stress application layer 14 may include at least one of SiO₂, quartz, graphite, h-BN, and SiN, so that a tensile stress provided by the stress application layer 14 for the ferroelectric layer 13 exceeds 1 GPa. For example, the material of the stress application layer 14 includes SiN. The tensile stress provided by the stress application layer 14 for the ferroelectric layer 13 may exceed 1.7 GPa.

In addition, in some other embodiments, as shown in FIG. 14, the material of the dielectric layer 15 may be the same as the material of the stress application layer 14. In this way, the coefficient of thermal expansion of the dielectric layer 15 is the same as the coefficient of thermal expansion of the stress application layer 14. Provided that the material of the dielectric layer 15 is the dielectric material with the small coefficient of thermal expansion, a tensile stress may be provided for the ferroelectric layer 13 by using the dielectric layer 15 without additionally disposing the stress application layer 14.

In still another embodiment, an embodiment of this application provides a preparation method for a chip. As shown in FIG. 15, the method may be implemented by using the following steps.

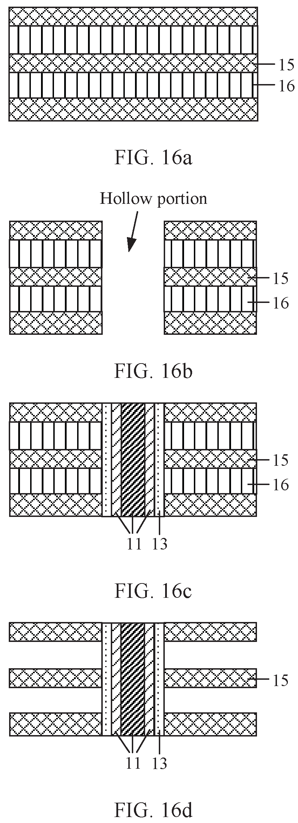

S110: As shown in FIG. 16a, form a plurality of dielectric layers 15 and a plurality of sacrificial layers 16 that are alternately stacked on a substrate 10.

In some possible implementations, the plurality of dielectric layers 15 and the plurality of sacrificial layers 16 are not limited in embodiments of this application, provided that the plurality of dielectric layers 15 are made of a dielectric material.

For example, materials of the plurality of dielectric layers 15 include SiO₂, and materials of the plurality of sacrificial layers 16 include silicon (Si).

S120: As shown in FIG. 16b, form a hollow portion in the plurality of dielectric layers 15 and the plurality of sacrificial layers 16, where the hollow portion penetrates the plurality of dielectric layers 15 and the plurality of sacrificial layers 16 in a direction from the substrate 10 to a second electrode 12.

In some possible implementations, the plurality of dielectric layers 15 and the plurality of sacrificial layers 16 may be etched by using an etching process to form the hollow portion. For example, the plurality of dielectric layers 15 and the plurality of sacrificial layers 16 may be etched through dry etching.

S130: As shown in FIG. 16c, sequentially fill the hollow portion with a ferroelectric layer 13 and a first electrode 11, where the ferroelectric layer 13 is located between the first electrode 11, and the plurality of dielectric layers 15 and the plurality of sacrificial layers 16.

In some possible implementations, processes of forming the ferroelectric layer 13 and the first electrode 11 are not limited in embodiments of this application. Optionally, the ferroelectric layer 13 may be formed by using a PECVD process or an ALD process, and the first electrode 11 may be formed by using a CVD process.

S140: As shown in FIG. 16d, remove the plurality of sacrificial layers 16 to form a spacing region; and then, as shown in FIG. 13, sequentially form a stress application layer 14 and a plurality of second electrodes 12 in the spacing region, where a coefficient of thermal expansion of the stress application layer 14 is less than a coefficient of thermal expansion of the dielectric layer 15, and the stress application layer 14 extends from between the second electrode 12 and the dielectric layer 15 that are adjacent to each other to between the second electrode 12 and the ferroelectric layer 13.

In some possible implementations, selective etching may be performed on the plurality of sacrificial layers 16 by using the etching process to remove the plurality of sacrificial layers 16. It should be noted that the materials of the plurality of sacrificial layers 16 are different from the materials of the plurality of dielectric layers 15 and a material of the ferroelectric layer 13, and an etching material for etching the plurality of sacrificial layers 16 does not etch the plurality of dielectric layers 15 and the ferroelectric layer 13.

In some possible implementations, after the stress application layer 14 is formed and before the plurality of second electrodes 12 are formed, the stress application layer 14 may be further annealed, to increase a tensile stress of the stress application layer 14 (a maximum tensile stress may reach 1.7 GPa).

In some other embodiments, in step S110, the plurality of sacrificial layers 16 and the plurality of second electrodes 12 may be first formed, and in step S140, the stress application layer 14 and the plurality of dielectric layers 15 may be first filled in the spacing region.

A reason why the second electrode 12 is formed in step S140 is that a high-temperature process present before the second electrode may be prevented from affecting the second electrode 12.

In addition, other explanations, descriptions, and beneficial effects of embodiments of this application are the same as those of the previous embodiment. Details are not described herein again.

The foregoing describes embodiments of this application with reference to the accompanying drawings. However, this application is not limited to the foregoing specific implementations. The foregoing specific implementations are merely examples instead of limitations. Inspired by this application, a person of ordinary skill in the art may further make modifications without departing from the purposes of this application and the protection scope of the claims, and all the modifications shall fall within the protection scope of this application.

## Claims

1. A chip, comprising a substrate, and a first electrode, a ferroelectric layer, and a second electrode that are sequentially stacked on the substrate, wherein
a surface that is of the ferroelectric layer and that faces the second electrode is a first surface, the second electrode covers a part of the first surface, and a part that is of the first surface and that is not covered by the second electrode is a first subsurface; and
the chip further comprises a stress application layer made of a dielectric material, a coefficient of thermal expansion of the stress application layer is less than a coefficient of thermal expansion of the second electrode, and the stress application layer extends from the first subsurface to a side wall of the second electrode.

2. The chip according to claim 1, wherein the stress application layer encircles the second electrode.

3. The chip according to claim 1 or 2, wherein the first electrode, the ferroelectric layer, and the second electrode are sequentially disposed on the substrate in the second direction.

4. The chip according to claim 3, wherein a surface that is of the ferroelectric layer and that faces the first electrode is a second surface, the first electrode covers a part of the second surface, and a part that is of the second surface and that is not covered by the first electrode is a second subsurface; and
the coefficient of thermal expansion of the stress application layer is less than a coefficient of thermal expansion of the first electrode, and the stress application layer further extends from the second subsurface to a side wall of the first electrode.

5. The chip according to claim 4, wherein the stress application layer completely covers side walls of the first electrode and the second electrode; and/or
the stress application layer completely covers the first subsurface and the second subsurface.

6. The chip according to any one of claims 1 to 5, wherein the coefficient of thermal expansion of the stress application layer is less than a coefficient of thermal expansion of tungsten.

7. The chip according to claim 6, wherein a material of the stress application layer comprises at least one of silicon dioxide, quartz, graphite, hexagonal boron nitride, silicon nitride, silicon, silicon germanium, and silicon carbide.

8. A chip, comprising a substrate and a three-dimensional ferroelectric capacitor disposed on the substrate, wherein the three-dimensional ferroelectric capacitor comprises a first electrode, a ferroelectric layer, a plurality of second electrodes, and a plurality of dielectric layers;
in a direction from the substrate to the three-dimensional capacitor, the plurality of second electrodes and the plurality of dielectric layers are alternately disposed, the ferroelectric layer and the first electrode penetrate the plurality of second electrodes and the plurality of dielectric layers, and the ferroelectric layer is disposed between the plurality of second electrodes and the first electrode; and
the chip further comprises a stress application layer made of a dielectric material, a coefficient of thermal expansion of the stress application layer is less than a coefficient of thermal expansion of the dielectric layer, and the stress application layer extends from between the second electrode and the dielectric layer that are adjacent to each other to between the second electrode and the ferroelectric layer.

9. The chip according to claim 8, wherein the coefficient of thermal expansion of the stress application layer is less than a coefficient of thermal expansion of the second electrode.

10. The chip according to claim 8 or 9, wherein a material of the stress application layer comprises at least one of silicon dioxide, quartz, graphite, hexagonal boron nitride, silicon nitride, silicon, silicon germanium, and silicon carbide.

11. A preparation method for a chip, comprising:
forming, on a substrate, a stress application layer made of a dielectric material, and a first electrode, a ferroelectric layer, and a second electrode that are stacked, wherein a surface that is of the ferroelectric layer and that faces the second electrode is a first surface, the second electrode covers a part of the first surface, a part that is of the first surface and that is not covered by the second electrode is a first subsurface, the chip further comprises a stress application layer made of a dielectric material, a coefficient of thermal expansion of the stress application layer is less than a coefficient of thermal expansion of the second electrode, and the stress application layer extends from the first subsurface to a side wall of the second electrode.

12. The preparation method for the chip according to claim 11, wherein before forming the stress application layer on the substrate, forming the first electrode, the ferroelectric layer, and the second electrode that are stacked comprises:
sequentially forming, on the substrate, the first electrode, the ferroelectric layer, and a conductive film layer that are stacked; and
etching the conductive film layer to obtain the second electrode.

13. The preparation method for the chip according to claim 11 or 12, wherein before forming the first electrode, the preparation method for the chip further comprises:
forming, on the substrate, a plurality of dielectric layers that are spaced apart and a plurality of stress application layers that are spaced apart, wherein the stress application layer covers a side wall of the dielectric layer and a surface that is of the dielectric layer and that faces away from the substrate, and the coefficient of thermal expansion of the stress application layer is less than a coefficient of thermal expansion of the first electrode; and
forming the first electrode comprises:
performing filling between the adjacent stress application layers with the first electrode.

14. A preparation method for a chip, comprising:
forming, on a substrate, a plurality of dielectric layers and a plurality of sacrificial layers that are alternately stacked;
forming a hollow portion in the plurality of dielectric layers and the plurality of sacrificial layers, wherein the hollow portion penetrates the plurality of dielectric layers and the plurality of sacrificial layers in a direction from the substrate to the second electrode;
sequentially filling the hollow portion with a ferroelectric layer and a first electrode, wherein the ferroelectric layer is located between the first electrode, and the plurality of dielectric layers and the plurality of sacrificial layers; and
removing the plurality of sacrificial layers to form a spacing region, and sequentially forming a stress application layer and a plurality of second electrodes in the spacing region, wherein a coefficient of thermal expansion of the stress application layer is less than a coefficient of thermal expansion of the dielectric layer, and the stress application layer extends from between the second electrode and the dielectric layer that are adjacent to each other to between the second electrode and the ferroelectric layer.

15. The preparation method for the chip according to claim 14, wherein forming the stress application layer in the spacing region comprises:
forming the stress application layer by using a plasma enhanced chemical vapor deposition process or an atomic layer deposition process.

16. An electronic device, comprising a circuit board and the chip according to any one of claims 1 to 7 or the chip according to any one of claims 8 to 10, wherein the chip is disposed on the circuit board.
